# EUROPÄISCHE PATENTSCHRIFT

(11) **EP 1 566 846 B1**
(45) Veröffentlichungstag und Bekanntmachung des Hinweises auf die Patenterteilung: **03.02.2016**
(21) Anmeldenummer: 05011759.7
(22) Anmeldetag: 27.07.1998
(51) Int. Cl.: H01L 33/48, H01L 33/62, H01L 33/64, H01L 25/075

(54) **Optoelektronisches Bauelement**
Optoelectronic device
Dispositif opto-électronique

(30) Priorität: 29.07.1997 DE 19732646
(43) Veröffentlichungstag der Anmeldung: 24.08.2005
(62) Teilanmeldung aus: 98947353.3
(73) Patentinhaber: OSRAM Opto Semiconductors GmbH, 93055 Regensburg (DE)
(72) Erfinder: Arndt, Karlheinz, 93077 Bad Abbach (DE)
(74) Vertreter: Epping - Hermann - Fischer

(56) Entgegenhaltungen:
- WO-A-98/20718
- DE-A1- 19 536 454
- JP-A- 6 204 604
- JP-A- 7 202 271
- JP-A- 60 081 877
- US-A- 5 146 310
- US-A- 5 519 576

## Beschreibung

Die Erfindung bezieht sich auf ein optoelektronisches Bauelement, bei dem ein optoelektronischer Chip mittels eines gut wärmeleitenden Verbindungsmittels auf einem Chipträgerteil eines Leiterrahmens (Leadframe) befestigt ist, der Leiterrahmen einen in einem Abstand zum Chipträgerteil angeordneten, mit einem elektrischen Kontakt des Chips elektrisch leitend verbunden Anschlussteil aufweist, und bei dem der Chip und zumindest jeweils ein Teilbereich des Chipträgerteiles und des Anschlussteiles von einer Umhüllung umgeben sind, derart, dass für eine Leiterplattenmontage bestimmte, im Leiterrahmen vorgesehene externe Anschlüsse des Chipträgerteiles und des Anschlussteiles aus der Umhüllung herausragen oder vollständig außerhalb der Umhüllung liegen. Sie bezieht sich im Speziellen auf ein optoelektronisches Bauelement mit einem optoelektronischen Halbleiterchip, insbesondere mit einem bei hoher Leistung betriebenen Leuchtdioden-Chip (LED).

Ein solches Bauelement ist beispielsweise aus der europäischen Patentanmeldung EP 400 176 bekannt. Hierin ist eine sogenannte TOPLED beschrieben, bei der ein lichtemittierender Halbleiterchip (LED-Chip) auf einem ebenen Chipträgerteil eines Leiterrahmens befestigt ist. Der Leiterrahmen setzt sich zusammen aus dem Chipträgerteil und einem in einem Abstand zu diesem, also elektrisch isoliert von diesem angeordneten Anschlussteil mit jeweils einem externen Anschluss. Der Chipträgerteil mit dem Halbleiterchip, der Anschlussteil und Teilbereiche der externen Anschlüsse sind von einer Umhüllung umgeben, die aus einem strahlungsundurchlässigen Grundkörper mit einer Ausnehmung und einem diese Ausnehmung ausfüllenden strahlungsdurchlässigen Fensterteil besteht. Der Chipträgerteil und der Anschlussteil sind derart von dem Grundkörper umgeben bzw. in diesen eingebettet, dass Teilbereiche der Oberseiten des Chipträgerteils und des Anschlussteils mit der verbleibenden Bodenfläche der Ausnehmung bündig abschließen. Der Halbleiterchip ist bis auf seine Unterseite, mit der er auf dem Chipträgerteil aufliegt, vollständig von dem strahlungsdurchlässigen Fensterteil umgeben. Die Ausnehmung und deren Innenflächen sind derart geformt und angeordnet, dass sie für die vom Halbleiterchip ausgesandte Strahlung einen im Wesentlichen kegelstumpfförmigen Reflektor bildet.

In der DE 19536454A1 ist ein optoelektronisches Bauelement beschrieben, bei dem zur Verbesserung der Wärmeableitung vom Halbleiterchip zwei externe Anschlüsse des Chipträgerteiles des Leiterrahmens gegenüber den externen Anschlüssen des Anschlußteiles verbreitert sind.

In der Druckschrift US 5 146 310 werden zwei breite Anschlüsse des Chipträgerteils eines Leiterrahmens zur Wärmeableitung an weit auseinander liegende Kontaktpunkte beschrieben.

Bei den oben beschriebenen bekannten optoelektronischen Bauelementen kommt es bei Betrieb des Halbleiterchips bei hohen Strömen und damit bei hoher Leistung, wie es beispielsweise bei sogenannten Power-LEDs der Fall ist, aufgrund von unzureichender Wärmeableitung vom Halbleiterchip, zu dessen starker Erhitzung. Diese Erhitzung führt häufig zur Beeinträchtigung der Funktionsfähigkeit des Halbleiterchips, wie z. B. beschleunigte Alterung, Abbrechen des Halbleiterchips vom Leiterrahmen, Abbrechen der Bonddrähte oder Zerstörung des Chips. Die bekannten verbreiterten externen Anschlüsse des Chipträgerteiles begünstigen eine Delamination des Kunststoffes vom Leiterrahmen, die z. B. ein Eindringen von Feuchtigkeit zum Halbleiterchip hervorrufen kann.

Der Erfindung liegt daher die Aufgabe zugrunde, das optoelektronische Bauelement der eingangs genannten Art so weiterzubilden, dass eine verbesserte Wärmeableitung vom Chip gewährleistet ist, ohne gleichzeitig die Gehäuseabmessungen wesentlich zu verändern und ohne gleichzeitig die Delaminationsgefahr wesentlich zu erhöhen.

Diese Aufgabe wird durch ein Bauelement mit den Merkmalen des Anspruches 1 gelöst.

Vorteilhafte Weiterbildungen der erfindungsgemäßen Bauelemente sind Gegenstand der Unteransprüche.

Bei dem erfindungsgemäßen Bauelement ist vorgesehen, dass der Chipträgerteil drei separate, mit dem Chipträgerteil thermisch leitend verbundene externe Anschlüsse aufweist, die an verschiedenen, einen Abstand voneinander aufweisenden Stellen der Umhüllung aus dieser herausragen und die derart geformt sind, daß sie im auf einer für die Montage des Bauelements vorgesehenen Leiterplatte montierten Zustand des Bauelements alle gleichzeitig auf der Anschluß- oder Leiterplatte aufliegen. Die im Betrieb des Bauelements im Chip entstehende Wärme wird folglich an drei verschiedenen Punkten in die Leiterplatte eingespeist und großflächig auf dieser verteilt. Dadurch wird eine deutlich verbesserte Wärmeableitung vom optoelektronischen Chip erzielt.

Bei dieser Ausführungsform des erfindungsgemäßen Bauelements verlaufen die externen Anschlüsse des Chipträgerteiles in Draufsicht auf den Leiterrahmen gesehen, ausgehend von dem Chipträgerteil getrennt voneinander im Wesentlichen sternförmig nach außen. Die Wärmeableitungspunkte vom Bauelement zur Leiterplatte hin weisen dadurch verhältnismäßig große Abstände voneinander auf, wodurch eine sehr großflächige Verteilung der im Betrieb des Bauelements über den Chipträgerteil und dessen externe Anschlüsse vom Chip abgeleiteten thermischen Energie auf die Leiterplatte erreicht wird.

Vorteilhafterweise weisen die externen Anschlüsse in dem Bereich, in dem sie sternförmig nach außen verlaufen, Längsmittelachsen auf, von denen zwei zueinander benachbarte jeweils einen Winkel von etwa 90° einschließen. Bei dieser Anordnung ist der Kunststoffbereich zwischen den Anschlüssen maximal, wodurch die Delaminationsgefahr z. B. bei Temperaturschwankungen verringert ist.

Ist ein Bauelement mit mindestens einem ersten und einem zweiten optoelektronischen Chip vorgesehen und weist der Chipträgerteil mindestens zwei externe Anschlüsse auf, die an verschiedenen einen Abstand voneinander aufweisenden Stellen der Umhüllung aus dieser herausragen, so gehört das Bauelement nicht zur Erfindung, sondern dient lediglich zu ihrer Erläuterung.

Der Leiterrahmen weist hier mindestens zwei Anschlussteile mit jeweils einem externen Anschluss auf, die ebenfalls seitlich aus der Umhüllung herausragen. Bevorzugt sind auch hier die externen Anschlüsse des Chipträgerteiles und der Anschlussteile in Draufsicht auf den Leiterrahmen gesehen im Wesentlichen sternförmig angeordnet, wodurch ein maximaler Abstand der externen Anschlüsse des Chipträgerteiles voneinander gewährleistet ist. Die im Betrieb des Bauelements über den Chipträgerteil und dessen externen Anschlüsse vom Chip abgeleitete thermische Energie wird dadurch an verhältnismäßig weit voneinander entfernten Punkten in die Leiterplatte eingespeist, so dass auch hier eine sehr gute Wärmeverteilung auf der Leiterplatte erzielt wird.

Bei dem letztgenannten Bauelement können die externen Anschlüsse des Chipträgerteiles in Draufsicht auf den Leiterrahmen gesehen bezüglich des Chipträgerteiles diagonal versetzt zueinander angeordnet sein. Sie ragen dann auf einander gegenüberliegenden Seitenflächen einer vorzugsweise im Wesentlichen quaderförmigen Umhüllung aus dieser heraus. Die Anschlussteile sind hierbei auf verschiedenen Seiten des Chipträgerteiles angeordnet und deren externe Anschlüsse ragen ebenfalls auf einander gegenüberliegenden Seitenflächen der Umhüllung aus dieser heraus. In Draufsicht auf den Leiterrahmen sind sie bezüglich des Chipträgerteiles zu den externen Anschlüssen des Chipträgerteiles zueinander entgegengesetzt diagonal versetzt angeordnet.

Um die Wärmeableitung von den Chips, falls notwendig, weiter zu verbessern, kann der Chipträgerteil auch mehr als zwei externe Anschlüsse aufweisen, die wiederum an verschiedenen einen Abstand von einander aufweisenden Stellen der Umhüllung aus dieser herausragen. Die Anzahl dieser externen Anschlüsse kann nach Bedarf je nach zulässiger Baugröße des Bauelements weiter erhöht werden.

Bei einem der Erläuterung dienenden, nicht erfindungsgemäßen Bauelement, das so auf einer Leiterplatte befestigt werden kann, dass bei dessen Betrieb die die vom Chip ausgesandte Strahlung im Wesentlichen parallel zur Leiterplatte abgestrahlt wird (seitlich emittierendes Bauelement), weist der Chipträgerteil mindestens zwei externe Anschlüsse und der Anschlussteil mindestens einen externen Anschluss auf, die getrennt voneinander an ein- und derselben Seitenfläche der Umhüllung aus dieser herausragen. Der externe Anschluss des Anschlussteiles ist hierbei bevorzugt zwischen den beiden externen Anschlüssen des Chipträgerteiles angeordnet.

Bei einer besonders bevorzugten Weiterbildung des letztgenannten Bauelements ist der externe Anschluss des Anschlussteiles schmäler als die beiden externen Anschlüsse des Chipträgerteiles. Selbstverständlich können optional auch bei den anderen oben genannten erfindungsgemäßen Bauelementen die externen Anschlüsse des Chipträgerteiles breiter sein als die externen Anschlüsse der Anschlussteile.

Bei einer Weiterbildung des oben genannten seitlich emittierenden Bauelements ist der Chipträgerteil zusätzlich mit mindestens einer Kühlfahne wärmeleitend verbunden, die auf einer anderen Seitenfläche der Umhüllung als die Anschlussteile aus dieser herausragt. Diese Kühlfahne alleine oder eine an diese Kühlfahne thermisch angeschlossene weitere Kühleinrichtung gewährleistet eine weiter verbesserte Wärmeableitung vom Chip.

Weitere Vorteile und bevorzugte Ausführungsformen ergeben sich aus den im folgenden in Verbindung mit den Figuren 1 bis 3b näher erläuterten Beispielen. Es zeigen:
Figur 1a eine schematische Darstellung einer Draufsicht eines Ausführungsbeispieles eines erfindungsgemäßen Bauelements mit einem einzigen optoelektronischen Chip,
Figur 1b eine schematische Darstellung eines Schnittes durch das Ausführungsbeispiel von Figur 1 entlang der Linie A-A,
Figur 2 eine schematische Darstellung einer Draufsicht eines erläuternden Beispiels eines Bauelements mit mindestens zwei optoelektronischen Chips,
Figur 3a eine schematische Darstellung einer Seitenansicht eines erläuternden Beispiels eines seitlich emittierenden Bauelements und
Figur 3b eine schematische Darstellung eines Schnittes durch das erläuternde Beispiel von Figur 3 entlang der in Figur 3 eingezeichneten Linie A-A.

In den Figuren sind gleiche und gleichwirkende Bestandteile der verschiedenen Beispiele immer mit denselben Bezugszeichen versehen.

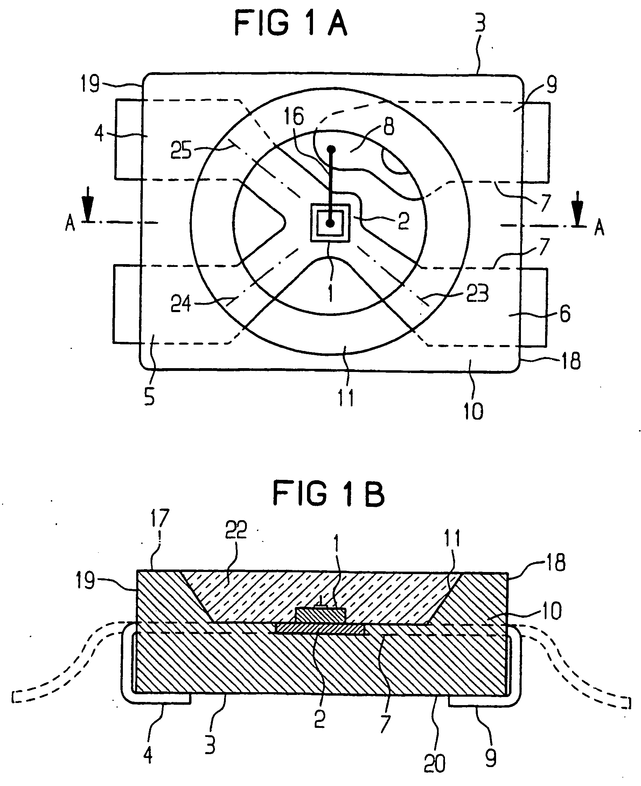

Bei dem Bauelement gemäß Figur 1 handelt es sich um ein Leuchtdioden-Bauelement, bei dem auf einem Chipträgerteil 2 eines Leiterrahmens (Leadframe) 7 ein lichtemittierender Halbleiterchip 1 (LED-Chip) mittels eines gut wärmeleitenden Verbindungsmittels, z. B. mittels eines metallischen Lotes befestigt ist. Drei separate externe Anschlüsse 4, 5, 6 erstrecken sich ausgehend vom Chipträgerteil 2 in drei verschiedene Richtungen nach außen. In einem Abstand zum Chipträgerteil 2 mit den externen Anschlüssen 4, 5, 6 ist ein Anschlussteil 8 mit einem externen Anschluss 9 angeordnet, der mittels eines Bonddrahtes 16 mit einem elektrischen Kontakt des LED-Chips 1, z. B. mit der Anodenkontaktierung verbunden ist. Eine zweite Kontaktmetallisierung (Kathodenkontaktierung) des LED-Chips 1 befindet sich beispielsweise an dessen dem Chipträgerteil 2 zugewandten Unterseite und ist mit dem Chipträgerteil 2 mittels dem in diesem Fall auch elektrisch leitenden Verbindungsmittel elektrisch leitend verbunden. Der Chipträgerteil 2 mit den externen Anschlüssen 4, 5, 6 dient folglich in diesem Fall sowohl als Kathodenanschluss als auch als thermischer Anschluß zur Wärmeableitung vom LED-Chip.

Ist die Kathodenkontaktierung nicht, wie im oben genannten Fall, an der Unterseite des Chips 1 angeordnet, sondern z. B. an dessen Oberseite, kann diese mittels eines Bonddrahtes mit dem Chipträgerteil 2 elektrisch leitend verbunden sein.

Der Chipträgerteil 2, der Anschlussteil 8 und Teilbereiche von deren externen Anschlüsse 4, 5, 6, 9 sind von einem im Wesentlichen quaderförmigen Grundkörper 10 einer Umhüllung 3 umschlossen, der eine Ausnehmung 11 aufweist. Die Ausnehmung 11 hat im Wesentlichen die Form eines Kegelstumpfes und reicht von einer zum Leiterrahmen 7 parallel liegenden Hauptfläche 17 des Grundkörpers 10 bis zum Leiterrahmen 7, wobei sich der Querschnitt der Ausnehmung 11 vom Leiterrahmen 7 zur Hauptfläche 17 des Grundkörpers 10 hin vergrößert. Der LED-Chip 1 befindet sich in der Ausnehmung 11, die mit einem strahlungsdurchlässigen Fensterteil 22, bevorzugt mit einem transparenten Kunststoffverguss versehen ist. Dieser Fensterteil 22 bildet zusammen mit dem Grundkörper 10 eine Umhüllung 3 des Bauelements. Die externen Anschlüsse 4, 5, 6, 9 ragen auf einander gegenüberliegenden Seitenflächen 18,19 des Grundkörpers 10 aus diesem heraus. Sie verlaufen innerhalb des Grundkörpers 10 ausgehend von dem Chipträgerteil 2 zunächst im Wesentlichen sternförmig auseinander und knicken im weiteren Verlauf ab, derart, dass sie die Seitenflächen 18,19 senkrecht durchdringen.

Der Chipträgerteil 2 liegt bevorzugt vollständig innerhalb der Bodenfläche der Ausnehmung 11.

Die externen Anschlüsse 4,5,6,9 weisen in dem Bereich, in dem sie sternförmig nach außen verlaufen, Längsmittelachsen 23,24,25 auf, von denen jeweils zwei zueinander benachbarte einen Winkel von etwa 90° einschließen.

Die externen Anschlüsse 4, 5, 6, 9 sind außerhalb des Grundkörpers 10 zunächst zu der der ersten Hauptfläche 17 gegenüberliegenden zweiten Hauptfläche 20 des Grundkörpers 10 hin und im weiteren Verlauf unterhalb des Grundkörpers 10 zu dessen Mitte hin gebogen. Sie können aber auch, wie in Figur 1b gestrichelt angedeutet, zu schwingenförmigen Anschluss-Stummeln gebogen sein. Auch dies stellt eine an sich in der Oberflächenmontage-Technik übliche Form der externen elektrischen Anschlüsse dar. Diese Arten von externen Anschlüssen für oberflächenmontierbare-Bauelemente (SMD) sind an sich bekannt und werden von daher an dieser Stelle nicht näher erläutert.

Die externen Anschlüsse sind folglich derart geformt, daß sie im auf einer für die Montage des Bauelements vorgesehenen Leiterplatte montierten Zustand des Bauelements alle gleichzeitig auf der Anschluß- oder Leiterplatte aufliegen.

Die Innenflächen der Ausnehmung 11 bilden einen Reflektor für die vom LED-Chip 1 im Betrieb des Bauelements ausgesandte Strahlung. Sie sind optional mit einem reflexionssteigernden Material beschichtet. Alternativ kann der Grundkörper aus einem reflexionssteigernden Material bestehen.

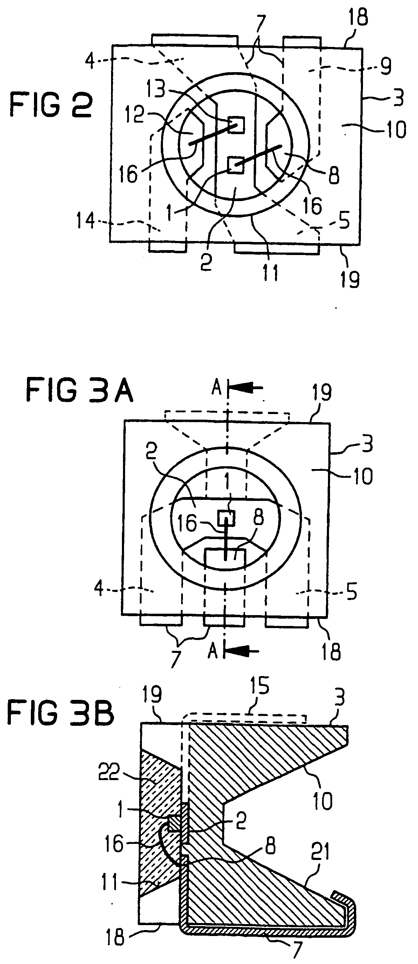

Bei dem erläuternden Beispiel von Figur 2 sind im Unterschied zum Ausführungsbeispiel der Figuren 1a und 1b auf einem Chipträgerteil 2 eines Leiterrahmens 7 zwei verschiedenfarbig leuchtende LED-Chips 1, 13 mittels eines thermisch und elektrisch leitenden Verbindungsmittels befestigt. Auf gegenüberliegenden Seiten des Chipträgerteiles 2 sind in einem Abstand zu diesem ein erster 8 und ein zweiter Anschlussteil 12 angeordnet, von denen jeder einen externen Anschluss 9,14 aufweist. Diese externen Anschlüsse 9,14 verlaufen parallel versetzt zueinander, erstrecken sich, gesehen vom Chipträgerteil 2, in zueinander entgegengesetzten Richtungen und ragen auf einander gegenüberliegenden Seitenflächen 18,19 des Grundkörpers 10 aus diesem heraus. Sie sind mittels Bonddrähten 16 mit den Anodenkontaktierungen der LED-Chips 1,13 elektrisch leitend verbunden.

Das Chipträgerteil 2 weist zwei externe Anschlüsse 4,5 auf, die sich ausgehend vom Chipträgerteil 2 im Wesentlichen ebenfalls parallel versetzt zueinander in zueinander entgegengesetzten Richtungen parallel zu den externen Anschlüssen 9,14 der Anschlussteile 8,12 erstrecken und auf einander gegenüberliegenden Seitenflächen 18,19 des Grundkörpers 10 aus diesem herausragen.

Wie beim Ausführungsbeispiel der Figuren 1a und 1b, weist der strahlungsundurchlässige Grundkörper 10 eine kegelstumpfförmige Ausnehmung 11 auf, die mit einem transparenten Fensterteil 22 versehen ist. Die LED-Chips 1,13 befinden sich in dieser der Ausnehmung 11.

Die externen Anschlüsse 4,5,9,14 ragen auf einander gegenüberliegenden Seitenflächen 18,19 des Grundkörpers 10 aus diesem heraus. Sie sind außerhalb des Grundkörpers 10 analog zum Ausführungsbeispiel gemäß Figuren 1a und 1b geformt.

Bei den oben beschriebenen Beispielen sind jeweils die Umhüllung 3 und die externen Anschlüsse 4,5,6,9,14 derart ausgebildet, dass im Betrieb des Bauelements die vom bzw. von den LED-Chip/s ausgesandte Strahlung im Wesentlichen senkrecht zur Montageoberfläche einer für die Montage des Bauelements vorgesehenen Leiterplatte abgestrahlt wird.

Bei dem erläuternden Beispiel der Figur 3a und 3b handelt es sich um ein sogenanntes seitlich emittierendes LED-Bauelement. Diese Art von Bauelement ist im allgemeinen Teil der Beschreibung bereits erläutert. Die Umhüllung 3 und die externen Anschlüsse 4,5 und 9 des Chipträgerteiles 2 bzw. des Anschlussteiles 8 sind bei diesem Bauelement derart ausgebildet, dass es mit einer Seitenfläche 20 des Grundkörpers 10 zur Montagefläche einer Leiterplatte hin auf dieser befestigt werden kann.

Hierzu weist ein Leiterrahmen 7 einen Chipträgerteil 2 auf, der mindestens zwei externe Anschlüsse 4,5 besitzt. Diese externen Anschlüsse 4,5 erstrecken sich zunächst ausgehend vom Chipträgerteil 2, auf dem ein LED-Chip 1 mittels eines thermisch und elektrisch leitenden Verbindungsmittels befestigt ist, in im Wesentlichen entgegengesetzten Richtungen nach außen. Im weiteren Verlauf knicken sie in dieselbe Richtung ab, so dass sie anschließend parallel zueinander in die gleiche Richtung verlaufen. Zwischen den beiden externen Anschlüssen 4,5 des Chipträgerteiles 2 ist ein Anschlussteil 8 mit einem externen Anschluss 9 angeordnet, der parallel zu den beiden externen Anschlüssen 4,5 des Chipträgerteiles in dieselbe Richtung wie diese verläuft.

Der Chipträgerteil 2, dessen externe Anschlüsse 4,5, der Anschlussteil 8 und dessen externer Anschluss 9 sind analog zu den beiden oben beschriebenen Beispielen mit einem strahlungsundurchlässigen Grundkörper 10 umschlossen, der eine kegelstumpfförmige Ausnehmung 11 aufweist, in dem der LED-Chip 1 angeordnet ist. Die Ausnehmung 11 ist auch hier mit einem strahlungsdurchlässigen Fensterteil 22 versehen, der bevorzugt aus einem strahlungsdurchlässigen Kunststoff besteht. Die externen Anschlüsse 4,5,9 ragen auf ein- und derselben Seitenfläche 18 des Grundkörpers 10 aus diesem heraus, sind außerhalb des Grundkörpers 10 nach unten in Richtung Rückseite des Grundkörpers 10 gebogen und sind im weiteren Verlauf entlang der Rückseite 21 des Grundkörpers 10 zu dessen Mitte hin gebogen. Die von der Seitenfläche 18 des Grundkörper 10 abgewandten Außenflächen der externen Anschlüsse 4,5,9 bilden eine Auflagefläche des Bauelements zu dessen Montage auf einer Leiterplatte.

Zur zusätzlichen Kühlung des LED-Chips 1 kann der Chipträgerteil 2 mit einer Kühlfahne 15 aufweisen (in den Figuren 3a und 3b gestrichelt eingezeichnet). Diese ragt auf einer der Seitenfläche 18, aus dem die externen Anschlüsse 4,5,9 herausragen, gegenüberliegenden Seitenfläche 19 des Grundkörpers 10 aus diesem heraus und ist außerhalb des Grundkörpers 10 zu dessen Rückseite 21 hin gebogen, derart, dass sie auf der Seitenfläche 19 aufliegt. An diese Kühlfahne 15 können optional weitere Kühleinrichtungen thermisch angeschlossen werden.

Bei allen oben beschriebenen Beispielen sind die externen Anschlüsse des Chipträgerteiles 2 breiter als die externen Anschlüsse des bzw. der Anschlussteile 8,12. Damit kann bei im Wesentlichen unveränderter Gehäuseabmessung ein weiter verbesserter Wärmeabtransport vom LED-Chip 1 erzielt werden. Die externen Anschlüsse 4,5,6,9,12 können aber auch alle dieselbe Breite haben.

Um eine weitere Verbesserung des Wärmeabtransports vom LED-Chip zu erreichen, sind auf einer für die Montage des Bauelements vorgesehenen Leiterplatte besonders große Löt-Pads vorgesehen. Diese sind ebenfalls sternförmig angeordnet und können so die vom LED-Chip abgeführte Wärme großflächig auf der Leiterplatte verteilen. Die Leadframes der erfindungsgemäßen Bauelemente führen die Wärme sternförmig vom LED-Chip zur Gehäuseaußenseite. Dadurch wird die Wärme an weit voneinander entfernt liegenden Punkten in die Platine eingespeist. Auf der Platine befinden sich bevorzugt um jeden Löt-Pad große, beispielsweise aus Kupfer bestehende Metallisierungen, die die Wärme auf der Leiterplatte verteilen. Der Wärmewiderstand der erfindungsgemäßen Gehäuse ist gegenüber dem Wärmewiderstand herkömmlicher LED-Gehäuse deutlich reduziert.

Bei den oben beschriebenen Gehäusen für LED-Chips handelt es sich um in der Halbleitertechnik bekannte Gehäuse für optoelektronische Bauelemente. Die besonderen Formen, die dazu verwendeten Materialien und Herstellverfahren werden von daher an dieser Stelle nicht mehr näher erläutert.

Die Beschreibung der Erfindung anhang des Ausführungsbeispiels ist selbstverständlich nicht als Einschränkung der Erfindung auf dieses Beispiel zu verstehen.

## Patentansprüche

1. Optoelektronisches oberflächenmontierbares Bauelement, bei dem ein optoelektronischer Chip (1) mittels einer gut wärmeleitenden Verbindungsmittels auf einem eine erste Hauptfläche (17) bildenden Chipträgerteil (2) eines Leiterrahmens (7) befestigt ist, bei dem der Leiterrahmen (7) ein in einem Abstand zum Chipträgerteil (2) angeordnetes Anschlussteil (8) aufweist, das mit einem elektrischen Kontakt des optoelektronischen Chips (7) elektrisch leitend verbunden ist, und bei dem der optoelektronische Chip (1) und ein Teil des Leiterrahmens (7) von einer einen Grundkörper (10) bildenden Umhüllung (3) umgeben sind, wobei der Grundkörper (10) eine der ersten Hauptfläche (17) gegenüberliegende nach außen gewandte zweite Hauptfläche (20) aufweist, und vier im Leiterrahmen (7) vorgesehene externe Anschlüsse (4,5,6,9) des Chipträgerteiles (2) und des Anschlussteile (8) aus der Umhüllung (3) herausragen und dort derart geformt sind, daß sie im auf einer für die Montage des Bauelements vorgesehenen Anschluß- oder Leiterplatte montierten Zustand des Bauelements alle gleichzeitig auf der Anschluß- oder Leiterplatte aufliegen,
wobei drei der externen Anschlüsse (4,5,6) durch mit dem Chipträgerteils (2) thermisch leitend verbundene Wärmeleit-Anschlüsse (4, 5, 6) ausgebildet sind, die, gesehen vom Chipträgerteil, innerhalb der Umhüllung getrennt voneinander im wesentlichen sternförmig nach außen verlaufen und an verschiedenen, einen Abstand voneinander aufweisenden Stellen an zwei gegenüberliegenden Seitenflächen der Umhüllung (3) aus dieser derart herausragen, dass eine im Betrieb des Bauelements im Chip entstehende Wärme an drei verschiedenen Punkten in die Anschluß- oder Leiterplatte eingespeist und großflächig auf dieser verteilt wird.

2. Optoelektronisches Bauelement nach Anspruch 1 ,
wobei die Umhüllung (3) vollständig aus einem strahlungsdurchlässigen Material besteht.

3. Optoelektronisches Bauelement nach einem der Ansprüche 1 bis 2,
wobei eine Ausnehmung (11) in der den Grundkörper (10) bildenden Umhüllung (3) vorgesehen ist, in der ein strahlungdurchlässiges Fensterteil (12) angeordnet ist,
wobei der Chipträgerteil (2) von dem strahlungsundurchlässigen Grundkörper (10) teilweise umhüllt ist und
wobei der Chip (1) in der Ausnehmung (11) angeordnet ist.

4. Optoelektronisches Bauelement nach Anspruch 3,
wobei die Ausnehmung (11) in ihrem Verlauf von innerhalb der Umhüllung (3) nach außen im Querschnitt aufgeweitet ausgebildet ist.

5. Optoelektronisches Bauelement nach Anspruch 4,
wobei die Innenfläche(n) der Ausnehmung (11) für die vom Chip (1) ausgesandte und/oder empfangende Strahlung als Reflektor ausgebildet ist/sind.

## Claims

1. Optoelectronic surface-mountable component, in which an optoelectronic chip (1) is fixed on a chip carrier part (2), forming a first main area (17), of a leadframe (7) by means of a connecting means having good thermal conductivity, in which the leadframe (7) has a connection part (8) which is arranged at a distance from the chip carrier part (2) and is electrically conductively connected to an electrical contact of the optoelectronic chip (7), and in which the optoelectronic chip (1) and a part of the leadframe (7) are surrounded by an encapsulation (3) forming a base body (10), the base body (10) having an outwardly facing second main area (20) opposite to the first main area (17), and four external connections (4, 5, 6, 9) of the chip carrier part (2) and of the connection part (8) which are provided in the leadframe (7) project from the encapsulation (3) and are shaped there in such a way that, in the state of the component mounted on a connection board or printed circuit board provided for the mounting of the component, said external connections all bear simultaneously on the connection board or printed circuit board,
wherein three of the external connections (4, 5, 6) are formed by heat-conducting connections (4, 5, 6) which are thermally conductively connected to the chip carrier part (2) and which, as seen from the chip carrier part, run outwards within the encapsulation separately from one another essentially in a starshaped manner and, at different mutually spaced apart locations at two opposite side areas of the encapsulation (3), project from the latter in such a way that heat that arises in the chip during the operation of the component is fed into the connection board or printed circuit board at three different points and is distributed over a large area on said board.

2. Optoelectronic component according to Claim 1,
wherein the encapsulation (3) is composed completely of a radiation-transmissive material.

3. Optoelectronic component according to either of Claims 1 and 2,
wherein provision is made of a recess (11) in the encapsulation (3) forming the base body (10), in which a radiation-transmissive window part (12) is arranged, wherein the chip carrier part (2) is partially encapsulated by the radiation-opaque base body (10) and wherein the chip (1) is arranged in the recess (11).

4. Optoelectronic component according to Claim 3,
wherein the recess (11) is formed such that its profile is expanded in cross section outwards from within the encapsulation (3).

5. Optoelectronic component according to Claim 4,
wherein the inner area(s) of the recess (11) is/are formed as a reflector for the radiation emitted and/or received by the chip (1).

## Revendications

1. Composant optoélectronique pouvant être monté en surface, dans lequel une puce optoélectronique (1) est fixée par le biais d'un moyen de liaison bon conducteur thermique sur une pièce de support de puce (2) d'un cadre conducteur (7), formant une première surface principale (17), dans lequel le cadre conducteur (7) présente une pièce de raccordement (8) disposée à distance de la pièce de support de puce (2), laquelle pièce de raccordement est connectée de manière électriquement conductrice à un contact électrique de la puce optoélectronique (7), et dans lequel la puce optoélectronique (1) et une partie du cadre conducteur (7) sont enveloppées d'une gaine (3) formant un corps de base (10), le corps de base (10) présentant une deuxième surface principale (20) tournée vers l'extérieur, opposée à la première surface principale (17), et quatre raccords externes (4, 5, 6, 9) de la pièce de support de puce (2) et de la pièce de raccordement (8), prévus dans le cadre conducteur (7), faisant saillie hors de la gaine (3) et étant formés à cet endroit de telle sorte que dans l'état monté sur une plaquette de raccordement ou de circuits imprimés prévue pour le montage du composant, ils soient tous disposés simultanément sur la plaquette de raccordement ou de circuits imprimés, trois des raccords externes (4, 5, 6) étant réalisés par des raccords thermoconducteurs (4, 5, 6) connectés de manière thermiquement conductrice à la pièce de support de puce (2), lesquels, vus de la pièce de support de puce, s'étendent vers l'extérieur essentiellement en forme stellaire séparément les uns des autres à l'intérieur de la gaine et sortent de celle-ci à différents endroits espacés les uns des autres au niveau de deux faces latérales opposées de la gaine (3), de telle sorte que de la chaleur générée dans la puce pendant le fonctionnement du composant soit introduite dans la plaquette de raccordement ou de circuits imprimés en trois points différents et soit répartie sur une grande surface sur celle-ci.

2. Composant optoélectronique selon la revendication 1, dans lequel la gaine (3) se compose entièrement d'un matériau perméable au rayonnement.

3. Composant optoélectronique selon la revendication 1 ou 2,
dans lequel il est prévu un évidement (11) dans la gaine (3) formant le corps de base (10), dans lequel une pièce de fenêtre perméable au rayonnement (12) est disposée,
dans lequel la pièce de support de puce (2) est en partie enveloppée par le corps de base (10) imperméable au rayonnement, et
dans lequel la puce (1) est disposée dans l'évidement (11).

4. Composant optoélectronique selon la revendication 3, dans lequel l'évidement (11) est réalisé en s'élargissant en section transversale dans son tracé depuis l'intérieur de la gaine (3) vers l'extérieur.

5. Composant optoélectronique selon la revendication 4, dans lequel la/les face(s) intérieure(s) de l'évidement (11) est/sont réalisée(s) comme réflecteur pour le rayonnement émis et/ou reçu par la puce (1).
